Europäisches Patentamt

**European Patent Office**

**Office européen des brevets**

(11) Numéro de publication: **0 169 980**
**A2**

(12) **DEMANDE DE BREVET EUROPEEN**

(21) Numéro de dépôt: **85104890.0**

(22) Date de dépôt: **23.04.85**

(51) Int. Cl.⁴: **G 11 C 17/00**

(30) Priorité: **27.04.84 FR 8406702**

(43) Date de publication de la demande:
**05.02.86 Bulletin 86/6**

(84) Etats contractants désignés:
**BE DE FR GB NL SE**

(71) Demandeur: **THOMSON-CSF TELEPHONE**
**146, Boulevard de Valmy**
**F-92707 Colombes(FR)**

(72) Inventeur: **Audrix, Jean-Claude**
**9, Avenue Nicolas Gillet**
**F-92700 Colombes(FR)**

(74) Mandataire: **Weinmiller, Jürgen et al,**
**Zeppelinstrasse 63**
**D-8000 München 80(DE)**

(54) **Mémoire morte réalisée en circuit intégré prédiffusé.**

㊲ Cette mémoire morte est du type à interrupteurs MOS, réalisée en circuit intégré prédiffusé comportant des rangées de transistors MOS alternativement de type P et de type N, à grilles non réunies d'une rangée à l'autre, organisés en cellules de base comportant chacune deux transistors adjacents de type P et deux transistors adjacents de type N de deux rangées adjacentes. Une mémoire morte de N mots de P éléments binaires est réalisée avec $\frac{N}{2} \times P$ cellules de base de ce type disposées et interconnectées sous forme matricielle.

Application à la réalisation de mémoires ROM en circuits intégrés.

EP 0 169 980 A2

./...

Croydon Printing Company Ltd

FIG_2

MEMOIRE MORTE REALISEE EN CIRCUIT INTEGRE PREDIFFUSE

La présente invention concerne une mémoire morte réalisée en circuit intégré prédiffusé.

On entend par circuit intégré prédiffusé un ensemble de transistors, par exemple de type MOS, qui sont confectionnés à l'avance sur un même substrat semiconducteur, suivant une structure régulière et indépendante de la fonction devant être réalisée ultérieurement par ce circuit intégré, et qui sont ensuite interconnectés à la demande, suivant le type de fonction à réaliser par ce circuit intégré, un certain nombre de zones réservées aux interconnexions étant pour cela prévu à la surface du circuit intégré.

Cette technique a pour avantage de concentrer sur la phase ultime du procédé de fabrication la réalisation de la partie "personnalisée" du circuit intégré, à savoir les interconnexions, et de reporter sur les phases précédentes la réalisation de la partie "standard" d'un circuit intégré, commune à l'ensemble des utilisateurs.

Elle a en revanche pour inconvénient, à partir d'un certain degré de complexité de la fonction à réaliser, de rendre très complexe la réalisation des interconnexions. En effet, les transistors étant disposés suivant des rangées parallèles, les interconnexions représentent un réseau essentiellement disposé entre ces rangées (il y a en fait un certain nombre d'interconnexions dans les rangées elles-mêmes).

Or on imagine aisément que les cas de figure sont extrêmement nombreux suivant l'architecture et le type de fonction à réaliser, ce qui cadre mal avec l'extrême rigidité de la structure décrite.

Un résultat bien connu d'une telle contradiction entre richesse d'un circuit en interconnexions et surface affectée à ces interconnexions (surface non modifiable) est que les constructeurs recommandent de laisser inutilisés un certain nombre de transistors (20% dans les cas relativement simples) pour faciliter l'opération de passage des interconnexions.

Suivant la complexité relative des fonctions à réaliser, on constate donc dans certains cas une perte de rendement des circuits en surface utilisée, ou à l'opposé des difficultés de réaliser le graphe d'interconnexion (lorsque le réseau d'interconnexion est très dense) et une perte de temps importante pour le réaliser. Dans certains cas la difficulté peut être telle que les constructeurs de circuits intégrés sont amenés à modifier la partie "standard" du circuit pour accorder une plus large place aux zones réservées aux interconnexions, ce qui se traduit bien sûr par une perte de rendement pour tous les utilisateurs, c'est-à-dire quelle que soit la fonction à réaliser.

La demande de Brevet français déposée le 26 Mars 1982 au nom de la demanderesse sous le numéro d'enregistrement national 82 05 245 fournit une solution à ce problème, qui consiste à faire se succéder de manière continue des rangées de transistors sur toute la surface du substrat, et à utiliser, lorsque c'est nécessaire, la surface occupée par certaines de ces rangées, alors non alimentées, pour effectuer des interconnexions horizontales (les rangées de transistors étant supposés horizontales). Cette technique correspond à la technique dite des circuits intégrés prédiffusés à interconnexions libres.

Par ailleurs, dans un circuit intégré prédiffusé classique, les transistors sont disposés suivant des rangées, ou lignes, qui sont alternativement de type N et de type P, et sont regroupés en cellules de base comportant chacune deux transistors de type N et deux transistors de type P, appartenant à deux lignes et à deux colonnes adjacentes. Ces cellules de base sont telles que deux transistors adjacents d'une même ligne ont une électrode de transfert (drain ou source) commune, et que deux transistors adjacents d'une même colonne ont leur électrode de commande réunie. Dans les circuits intégrés prédiffusés à interconnexions libres, il est également prévu, pour faciliter les interconnexions, de ne pas réunir les grilles des transistors d'une rangée de type P aux grilles des transistors de la rangée N suivante.

La présente invention concerne la réalisation d'une mémoire morte (ou ROM) en circuit intégré, plus particulièrement du type prédiffusé à interconnexions libres. Elle concerne plus spécialement une mémoire morte dans laquelle chaque point mémoire (ou cellule élémentaire de mémoire) est réalisé au moyen d'un interrupteur MOS, lui même réalisé au moyen de deux transistors MOS, l'un de type P, l'autre de type N, en parallèle, c'est-à-dire ayant une de leurs électrodes de transfert réunie pour former l'entrée de l'interrupteur (à laquelle est appliquée le niveau logique à mémoriser) et l'autre électrode de transfert réunie pour former la sortie de l'interrupteur, leur électrode de commande (ou grille) repective recevant deux signaux de commande complémentaires (A, $\bar{A}$) repré-sentant la commande de l'interrupteur.

La réalisation d'une mémoire morte de N mots de P éléments binaires implique donc la réalisation de N x P interrupteurs de ce type, dont les sorties correspondant à des éléments binaires de même rang de mots différents sont réunies entre elles.

Or, du fait de la commande des deux transistors constitutifs d'un interrupteur au moyen de deux signaux complémentaires, avec les circuits intégrés prédiffusés classiques, à grilles réunies, la réalisation de N x P interrupteurs implique l'utilisation de N x P cellules de base de ce circuit, dont deux transistors sur quatre sont inutilisés.

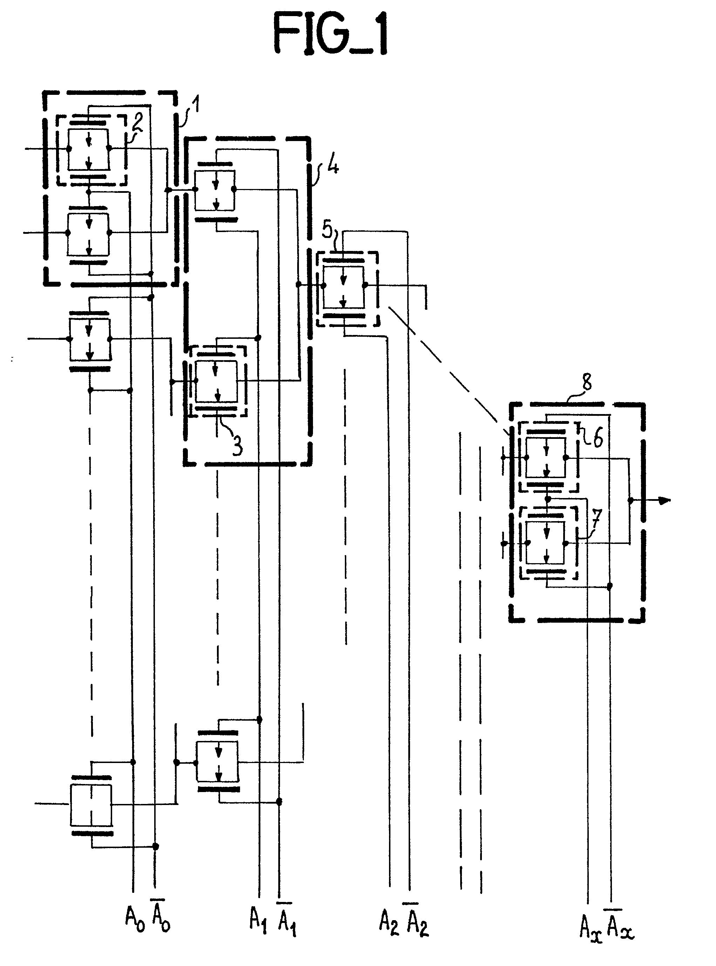

Pour éviter une telle perte de surface, une autre structure a été proposée (montrée sur la figure 1), consistant à affecter ces deux transistors inutilisés à la réalisation d'un autre point mémoire, soit au total deux points mémoire par cellule de base,c'est-à-dire, pour chacun des P éléments binaires, un ensemble de $\frac{N}{2}$ cellules de base telles que la cellule de base 1. Mais, du fait de la connexion des grilles, la commande de l'un des points mémoire de chaque cellule de base est nécessairement dépendante (plus précisément, complémentaire) de la commande de l'autre point mémoire, d'où la nécessité d'une structure "en pyramide", dans laquelle les N interrupteurs, tels que l'interrupteur 2, ainsi obtenus ont leurs sorties reliées deux à deux, sont commandés par les mêmes signaux $A_0$, $\bar{A}_0$, et sont suivis d'un ensemble analogue de $\frac{N}{2}$ interrupteurs, tels que l'interrupteur 3, (soit $\frac{N}{4}$ cellules de base, telles que la cellule de base 4), commandés par les mêmes signaux $A_1$, $\bar{A}_1$. Ce dernier ensemble est à son tour suivi d'un ensemble de $\frac{N}{4}$ interrupteurs, tels que l'interrupteur 5 (soit $\frac{N}{8}$ cellules de base) commandés par les mêmes signaux $A_2$, $\bar{A}_2$, et ainsi de suite jusqu'à ne plus obtenir que deux interrupteurs 6 et 7 (soit une seule cellule de base 8) commandés par les mêmes signaux $A_x$, $\bar{A}_x$ (avec x fonction de N). Cette structure en pyramide nécessite au total (2N-2) P interrupteurs, soit (N-1) P cellules de base d'un circuit intégré, d'où un léger gain en surface utilisée par rapport à la structure précédente, bien que ce nombre reste encore élevé.

La présente invention a pour objet une structure différente, adaptée aux circuits intégrés du type prédiffusé à interconnexions libres, et permettant de réduire dans des proportions sensiblement plus importantes le nombre de cellules de base d'un circuit intégré nécessaires à la réalisation d'une mémoire morte.

La mémoire morte suivant l'invention, à N mots de P éléments binaires, du type à interrupteurs MOS aptes à fournir sur leur sortie un état logique appliqué en permanence sur leur entrée, réalisée en circuit intégré du type prédiffusé comportant des rangées de transistors MOS alternativement de type P et de type N, à grilles non réunies d'une rangée à l'autre, organisés en cellules de base comportant chacune deux transistors adjacents de type P et deux transistors adjacents de type N de deux rangées adjacentes, comporte $\frac{N}{2} \times P$ cellules de base disposées sous forme d'une matrice à $\frac{N}{2}$ lignes et P colonnes, les transistors de chacune de ces cellules de base étant montés de manière à réaliser deux interrupteurs sur les entrées desquels sont appliqués des états logiques correspondant à deux éléments binaires de même rang p de deux mots de rangs n différents (n et p variant respectivement de 0 à N-1 et de 0 à P-1), les sorties de ces deux interrupteurs étant réunies, l'ensemble des sorties ainsi obtenues pour toutes les cellules de base disposées suivant une même colonne de rang p étant réunies pour former la sortie de rang p de la mémoire, et l'ensemble des cellules de base disposées suivant une même ligne de rang n étant commandées par les mêmes signaux $A_n$, $\bar{A}_n$ pour l'un des deux interrupteurs constitutifs de chaque cellule de base, et $A_{n+1}$, $\bar{A}_{n+1}$ pour l'autre interrupteur.

Les objets et caractéristiques de la présente invention apparaîtront plus clairement à la lecture de la description d'un exemple de la réalisation, faite en relation avec les dessins ci-annexés dans lesquels :

- la figure 1 (décrite précédemment) est un schéma d'une mémoire morte suivant l'état de la technique, réalisés en circuit intégré de type classique.

- la figure 2 est un schéma d'une mémoire morte suivant l'invention, réalisée en circuit intégré du type prédiffusé à interconnexions libres.

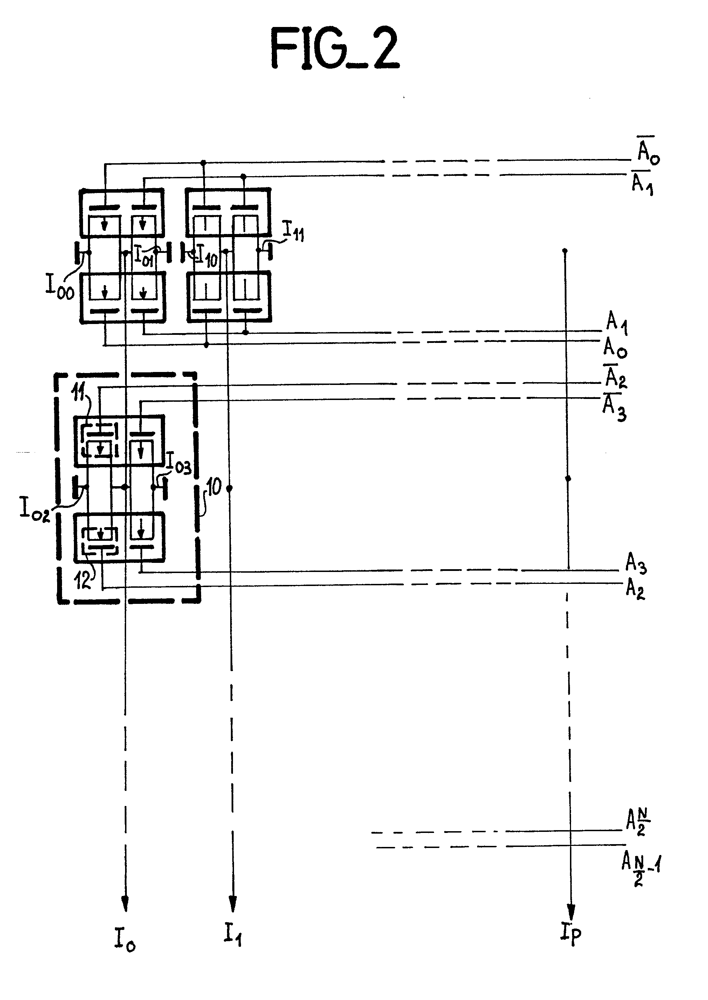

La mémoire morte représentée sur la figure 2 est une mémoire morte à N mots de P éléments binaires. Elle est réalisée avec seulement $\frac{N}{2}P$ cellules de base, telles que la cellule de base 10, d'un circuit intégré prédiffusé à interconnexions libres, comportant chacune deux points mémoire commandés de manière indépendante. Chaque point mémoire est réalisé au moyen d'un interrupteur MOS comportant lui-même deux transistors MOS en parallèle de types opposés (N et P) et à grilles non réunies, tels que les interrupteurs 11 et 12.

Les $\frac{N}{2}P$ cellules de base de cette mémoire sont disposées sous forme d'une matrice à $\frac{N}{2}$ lignes et P colonnes, ce qui, compte tenu de l'organisation matricielle des cellules de base d'un circuit intégré prédiffusé non interconnecté, et à l'inverse de la structure en pyramide précédente, simplifie les interconnexions et assure une compacité optimale.

Les deux points mémoire de chaque cellule de base ont leurs sorties réunies et mémorisent un élément binaire de même rang de deux mots successifs. Ainsi les deux points mémoire de la cellule de base 10 située au croisement de la deuxième ligne et de la première colonne mémorisent respectivement le bit de rang 0 du $2^{ième}$ mot $(I_{02})$ et le bit de rang 0 du $3^{ième}$ mot $(I_{03})$.

L'ensemble des sorties des cellules de base situées sur une même colonne sont réunies pour fournir, lorsque cette mémoire est lue, un élément binaire de rang donné du mot sélectionné par adressage de la mémoire. Ainsi les cellules de base de la première colonne fournissent l'élément binaire de rang 0, $I_0$, du mot sélectionné. L'adressage de la mémoire s'effectue par la commande des grilles de l'ensemble des transistors formant cette mémoire. L'adressage étant exclusif par mots, et chaque cellule de base comportant deux points mémoire, l'ensemble des cellules d'une même ligne est commandé par les mêmes signaux, qui sont au nombre de quatre, tels que les signaux $A_0$ , $\bar{A}_0$ , $A_1$ , $\bar{A}_1$ pour la première ligne, les signaux $A_0$ et $\bar{A}_0$ intervenant pour la commande de l'un des deux points mémoire de chaque cellule de base, et les signaux $A_1$ et $\bar{A}_1$ pour la commande de l'autre point mémoire.

Outre sa compacité et sa facilité d'interconnexion, cette mémoire présente un autre avantage qui est sa facilité d'extention, dûe à la répétitivité de sa structure.

## REVENDICATIONS

1. Mémoire morte, à N mots de P éléments binaires, du type à interrupteurs MOS aptes à fournir sur leur sortie un état logique appliqué en permanence sur leur entrée, réalisée en circuit intégré du type prédiffusé comportant des rangées de transistors MOS alternativement de type P et de type N, à grilles non réunies d'une rangée à l'autre, organisés en cellules de base comportant chacune deux transistors adjacents de type P et deux transistors adjacents de type N de deux rangées adjacentes, caractérisée en ce qu'elle comporte $\frac{N}{2}$ x P cellules de base disposées sous forme d'une matrice à $\frac{N}{2}$ lignes et P colonnes, les transistors de chacune de ces cellules étant montés de manière à réaliser deux interrupteurs sur les entrées desquels sont appliqués des états logiques correspondant à deux éléments binaires de même rang p de deux mots de rangs n différents (n et p variant respectivement de 0 à N-1 et de 0 à P-1), les sorties de ces deux interrupteurs étant réunies, l'ensemble des sorties ainsi obtenues pour toutes les cellules de base disposées suivant une même colonne de rang p étant réunies pour former la sortie de rang p de la mémoire, et l'ensemble des cellules de base disposées suivant une même ligne de rang n étant commandées par les mêmes signaux $A_n$ , $\bar{A}_n$ pour l'un des deux interrupteurs constitutifs de chaque cellule de base, et $A_{n+1}$ , $\bar{A}_{n+1}$ pour l'autre interrupteur

2. Mémoire morte suivant la revendication 1, caractérisée en ce qu'elle est réalisée en circuit intégré du type prédiffusé à interconnexions libres.

FIG_1

# FIG_2